# EUROPEAN PATENT SPECIFICATION

(11) **EP 2 035 496 B1**
(45) Date of publication and mention of the grant of the patent: **30.07.2014**
(21) Application number: 07786817.2
(22) Date of filing: 25.06.2007
(51) Int. Cl.: C08K 5/00, C08F 2/46, C08F 2/22, G03F 7/031

(54) **WATER BASED CONCENTRATED PRODUCT FORMS OF PHOTOINITIATORS MADE BY A HETEROPHASE POLYMERIZATION TECHNIQUE**
MIT HETEROPHASIGEM POLYMERISIERUNGSVERFAHREN HERGESTELLTE KONZENTRIERTE PRODUKTFORMEN VON FOTOINITIATOREN AUF WASSERBASIS
FORMES CONCENTRÉES À BASE D'EAU DE PHOTOAMORCEURS OBTENUES PAR TECHNIQUE DE POLYMÉRISATION HÉTÉROPHASIQUE

(30) Priority: 04.07.2006 EP 06116586
(43) Date of publication of application: 18.03.2009
(73) Proprietor: BASF SE, 67056 Ludwigshafen (DE)
(72) Inventor: SCHELLENBERG, Carsten, 4057 Basel (CH); AUSCHRA, Clemens, 79106 Freiburg (DE); PETER, Wolfgang, 79395 Neuenburg am Rhein (DE); PIRRUNG, Frank Oliver Heinrich, 79589 Binzen (DE); TANABE, Junichi, Amagasaki-shi, Hyogo 661-0044 (JP)
(86) International application number: PCT/EP2007/056290
(87) International publication number: WO 2008/003601

(56) References cited:
- WO-A-2005/023878
- GB-A- 1 478 987
- US-A- 4 965 294

## Description

The instant invention pertains to concentrated aqueous polymer dispersions with a particle size of less than 1000 nm containing photoinitiators and / or photolatent catalysts, prepared by heterophase radical polymerization of ethylenically unsaturated monomers in the presence of photoinitiators or photolatent catalysts. Another aspect of the invention is a process for the preparation of such aqueous dispersions and their use.

Photoinitiators (PI) like organic alpha-hydroxyketones, alpha-aminoketones and BAPO are state of the art additives to cure UV reactive coatings and ink formulations under the irradiation of UV light of a defined wave length.
In water based systems many of the well-established photoinitiators are difficult to incorporate due to insolubility and/or incompatibility with the aqueous formulations. Depending on the type of paint formulation and the type of photoinitiator, it can be impossible to generate a stable uniform mixture. In other cases it can be that the initial homogeneous formulations show instability upon storage with separation of photoinitiator and/or other components, and/or phenomena of floating, sedimentation, serum formation, gelation, etc prior to complete curing. Such phenomena caused by incompatibility of the photoinitiator are detrimental for the coatings performance, due to insufficient and inhomogeneous cure of the film.

US Patent US4,965,294 (Merck) discloses an aqueous photoinitiator dispersion useful for incorporation into aqueous dispersions of radiation curable binder systems, comprising 10-50wt% of a photoinitiator and 5-50wt% of a non-ionic surfactant.

The International Publication WO97/004361 describes heterogeneous photoinitiators in micro particle form, which consist of a finely divided substrate material to which identical or different photoinitiators are covalently bonded. Thus, dissolving of the photoinitiators can be avoided.

The International Publication WO2005/023878 (Ciba) discloses a process for the preparation of concentrated aqueous polymer dispersions with a particle size of less than 1000 nm comprising the steps of polymerizing at least one ethylenically unsaturated monomer in the presence of a organic light stabilizer by heterophase radical polymerisation. The poly-initiator can be a free radical initiator or a photoinitiator. After polymerization the photoinitiator is used up.

GB 1478987 (Bayer) discloses alpha-beta-mono-olefinically unsaturated monomers which are water-soluble or are capable of forming water-soluble salts. The monomers are converted into the state of a solution in the water phase of a water-in-all emulsion. Their polymerisation is carried out in the W/O emulsion with the aid of photoinitiators which are soluble in the water phase or oil phase and with the aid of UV light. After polymerization the photoinitiator is used up.

There is still a need to provide solutions to incorporate photoinitiators in aqueous formulations.

It has now been found that concentrated aqueous polymer dispersions with a particle size of less than 1000 nm can be prepared by heterophase radical polymerization of ethylenically unsaturated monomers in the presence of photoinitiators and / or photolatent catalysts, wherein the weight ratio between the photoinitiator (and / or photolatent catalyst) and the resulting polymer carrier is greater than 35 parts of photoinitiator to 100 parts of the polymer carrier.

The term "photoinitiator" includes photolatent catalysts.

One aspect of the invention is concentrated aqueous polymer dispersion with an average particle size of less than 1000 nm comprising
a) a polymer carrier prepared by heterophase radical polymerization of at least one ethylenically unsaturated monomer in the presence of
b) a photoinitiator and / or photolatent catalyst and
c) optionally a non-ionic, cationic or anionic surfactant,
wherein the weight ratio of the photoinitiator and / or photolatent catalyst to the polymer carrier is greater than 35 parts of photoinitiator and / or photolatent catalyst per 100 parts of polymer carrier, wherein the photoinitiator is selected from alpha-hydroxyketones, bisacylphosphine oxides or phenylglyoxylates.

Preferred is a concentrated aqueous polymer dispersion wherein the weight ratio of the photoinitiator and / or photolatent catalyst to the polymer carrier is equal or greater than 50 parts per 100 parts of polymer carrier.

Preferably more than one ethylenically unsaturated monomer is used. When the polymerization is carried out with two or more monomers, at least one may carry two unsaturated functionalities in order to provide a certain degree of crosslinking. For example the amount of the difunctional monomer may vary from 0.5 to 20 % by weight based on the total weight of the monomer mixture.

Preferably the average particle size is less than 500 nm, more preferably less than 250 nm.

Droplet (oil/water emulsion) as well as particle (polymer dispersion) size can be measured by using dynamic light scattering (DLS) technique (also known as photon correlation spectroscopy (PSC) or quasi-elastic light scattering (QELS)). For this kind of measurement a NICOMP particle sizer (NICOMP Model 380, Particle Sizing System, Santa Barbara, CA, USA) with a fixed scattering angle of 90° can be used for example. The measurement leads to the mean diameter D_{INT} (intensity weighted).

The total solids content of the concentrated aqueous polymer dispersion is for example more than 20%, for instance more than 30% and preferably more than 40% by weight based on the total weight of the aqueous dispersion.

The photoinitiator or photolatent catalyst is preferably soluble in the monomer or monomer mixture and insoluble or poorly soluble in water. The term "poorly soluble in water " is to be understood as being virtually insoluble in water or show limited solubility of e.g. < 10% by wt, preferably < 5% by wt, most preferred < 2% by wt%.

The photoinitiators are selected from
1. Alpha-hydroxyketones (AHK), alpha-alkoxyketones(benzildimethylketals DBK) and alpha-aminoketones (AAK),
2. Benzophenones,
3. Mono- and bisacylphosphine oxides (BAPO),
4. Phenyl-glyoxylates,
5. Isopropylthioxanthone (ITX),
6. Oxime-esters,
7. Aminobenzoates,
8. Latent acids and bases;
and blends thereof.

In one aspect of the invention blends of photoinitiators are used. Preferably used are blends of alpha hydroxyketones with benzophenones, alpha hydroxyketones with bisacylphosphine oxides, alpha hydroxyketones with benzophenones and with bisacylphosphine oxides as well as blends of mono-and bisacylphosphine oxides.

Suitable photoinitiators are:
**1. Alpha-hydroxyketones, alpha-alkoxyketones or alpha aminoketones** Alpha-hydroxyketones or alpha-alkoxyketones may be of the formula I 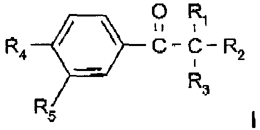 wherein
   - **R₁**: is hydroxy, C₁-C₁₆-alkoxy, morpholino, dimethylamino or -O(CH₂CH₂O)₁₋₂₀-C₁-C₁₆-alkyl;
   - **R₂** and **R₃**: independently of one another are hydrogen, C₁-C₆-alkyl, C₁-C₁₆-alkoxy or -O(CH₂CH₂O)₁₋₂₀-C₁-C₁₆-alkyl; or unsubstituted phenyl or benzyl; or phenyl or benzyl substituted by C₁-C₁₂-alkyl; or R₂ and R₃ together with the carbon atom to which they are attached form a cyclohexyl ring; with the proviso that R₁, R₂ and R₃ not all together are C₁-C₁₆-alkoxy or -O(CH₂CH₂O)₁₋₂₀-C₁-C₁₆-alkyl,
   - **R₄**: is hydrogen, C₁-C₁₈-alkyl, C₁-C₁₈-alkoxy, -OCH₂CH₂-OH, -OCH₂CH₂-O-CO-CH=CH₂, -OCH₂CH₂-O-CO-C(CH₃)=CH₂, morpholino, SCH₃, a group 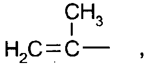 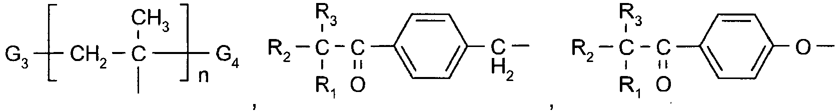
   **n** is 2-10;
   **G₃** and **G₄** independently of one another are hydrogen or methyl;
   - **R₅**: is hydrogen or C₁-C₁₈-alkoxy.

Examples of **alpha-hydroxyketones** (AHK) are:
1-Hydroxy-cyclohexyl-phenyl-ketone (IRGACURE^{®}184) and similar compounds as disclosed in the European patent application EP-003002 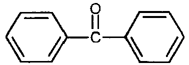 or blends containing IRGACURE^{®}184 such as:
   a blend of IRGACURE^{®}184 with benzophenone or
   a blend of IRGACURE^{®}184 with benzophenone and Lucirin TPO 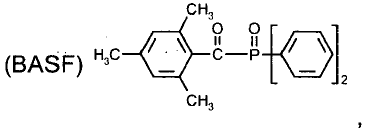
or a blend of IRGACURE^{®}184 with (DAROCUR^{®} 1173) 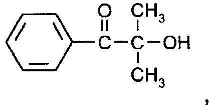
or a blend of IRGACURE^{®}184 with bis(2,6-dimethoxybenzoyl)-2,4,4- trimethylpentyl-phosphineoxid 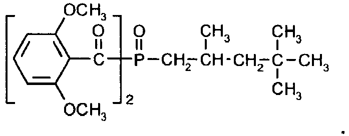 1-[4-(2-Hydroxyethoxy)-phenyl]-2-hydroxy-2-methyl-1-propane-1-one; (IRGACURE^{®}2959) and similar compounds as disclosed in the European patent application EP-216884. 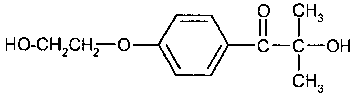 4[(2-Acryloxyethoxy)-benzoyl]-1-hydroxy-1-methyl ethane and similar compounds as disclosed in the European patent application EP 217205. 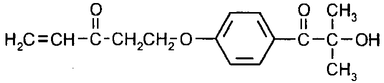 Poly-[4-(2-acryloyloxyethoxy)-phenyl]-2-hydroxy-2-propylketone and similar compounds as disclosed in the European patent application EP0258719. 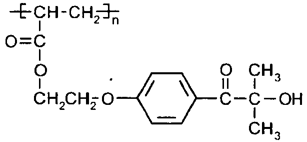 2-Hydroxy-2-methyl-1-phenyl-propan-1-one (DAROCUR^{®} 1173) 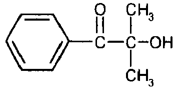 and similar compounds as disclosed in US4347111.
   2-Hydroxy-2-methyl-1-(4-dodecyl-phenyl)-propanone (DAROCUR^{®} 953) 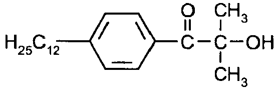 2-Hydroxy-2-methyl-1-(4-isopropyl-phenyl)-propanone (DAROCUR^{®} 1116) 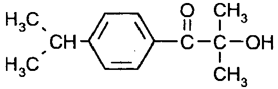
or blends containing DAROCUR^{®} 1173 such as
   DAROCUR^{®} 1664: blend with 2-isopropylthioxanthone
   (DAROCUR^{®} ITX) 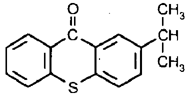 DAROCUR^{®} 3724: blend with benzophenone 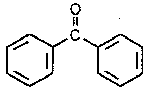 DAROCUR^{®} 4043: blend with ITX and 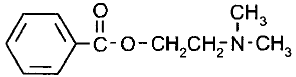 DAROCUR^{®} 4265: blend with diphenyl(2,4,6-trimethylbenzoyl)- phosphine oxide (Lucirin TPO) 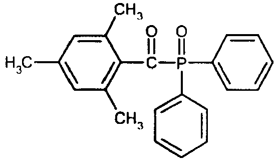 DAROCUR^{®} 4265: blend with benzophenone and
   Esacure TZT 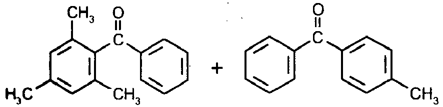
or blends of DAROCUR^{®} 1173 with bis(2,6-dimethoxybenzoyl)-2,4,4- trimethylpentyl-phosphinoxide 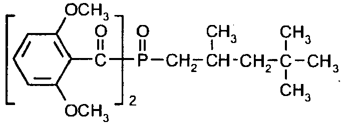
or blends of DAROCUR^{®} 1173 with bis(2,4,6-trimethylbenzoyl)- phenylphosphine oxide (IRGACURE^{®} 819) 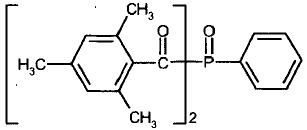
or blends of (DAROCUR^{®} 1173) with IRGACURE^{®} 819 and 2,4,6-trimethylbenzoyl-phenyl phosphinic acid ethyl ester

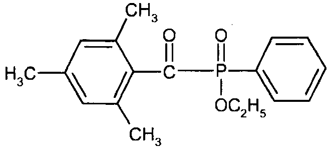

Another example of an alpha hydroxy ketone is 2-hydroxy-1-{1-[4-(2-hydroxy-2-methyl-propionyl)-phenyl]-1,3,3-trimethyl-indan-5-yl}-2-methyl-propan-1-one (ESACURE KIP 150) (Lamberti) and similar compounds as disclosed in US Patent 4 987 159. 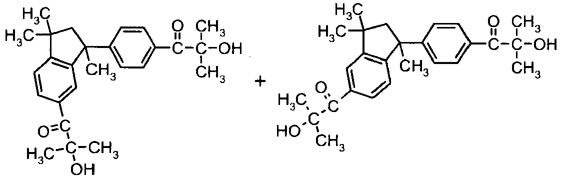 or blends with DAROCUR^{®} 1173 sold as Esacure KIP 100F.
2-Hydroxy-1-{4-[4-(2-hydroxy-2-methyl-propionyl)-benzyl]-phenyl}-2-methyl-propan-1-one and similar compounds as disclosed in WO03/040076. 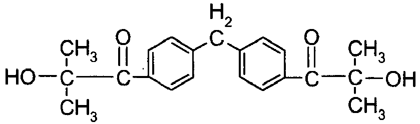 2-Hydroxy-1-{4-[4-(2-hydroxy-2-methyl-propionyl)-phenoxy]-phenyl}-2-methyl-propan-1-one, and similar compounds as disclosed in WO04/009651.

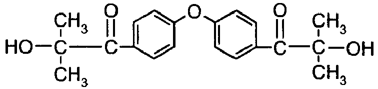

Trifunctional alpha-hydroxyketones as disclosed in WO04/099262 which are compounds of the formula 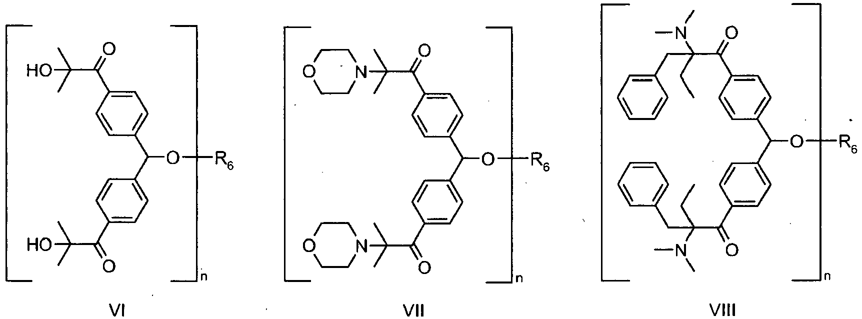 wherein
- n: is 1 or 2, and
- R₆: is an n-valent radical of linear or branched C₂-C₁₆alkyl the carbon chain of which may be interrupted by cyclohexanediyl, phenylene, -CH(OH)-, -C(CH₂-CH₂-OH)₂-, -C(CH₃)(CH₂-CH₂-OH)-, -C(C₂H₅)(CH₂-CH₂-OH)-, -N(CH₃)-, -N(CH₂-CH₂-OH)-, -CO-O-, -O-CO-, -Si(CH₃)₂-, -Si(CH₃)₂-O-Si(CH₃)₂-, -O-Si(CH₃)₂-O-, -O-Si(CH₃)(O-CH₃)-O-, 5-(2-hydroxyethyl)-[1,3,5]triazinane-2,4,6-trione-1,3-diyl and / or by from one to six oxygen atoms, or
- R₆: is an n-valent radical of linear or branched -CO-NH-(C₂-C₁₆alkylene)-(NH-CO)ₙ₋₁- or linear or branched -CO-NH-(C₀-C₉alkylene)-(NH-CO)ₙ₋₁- which may be interrupted by one or two phenylene, methylphenylene, phenylene-O-phenylene, cyclohexanediyl, methylcyclohexanediyl, trimethylcyclohexanediyl, norbornanediyl, [1-3]diazetidine-2,4-dione-1,3-diyl, 5-(6-isocyanatohexyl)-[1,3,5]triazinane-2,4,6-trione-1,3-diyl or 3-(6-isocyanatohexyl)-biuret-1,5-diyl radical(s).

Examples are:
2-hydroxy-1-(4-{hydroxy-[4-(2-hydroxy-2-methyl-propionyl)-phenyl]-methyl}-phenyl)-2-methyl-propan-1-one 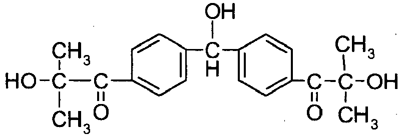
bis[4-(2-hydroxy-2-methyl-propionyl)-phenyl]-methoxymethane 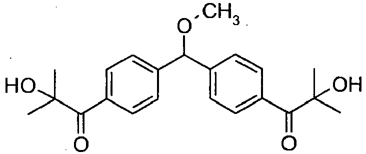
2-hydroxy-1-(4-{[(2-hydroxy-ethyl)-methyl-amino]-[4-(2-hydroxy-2-methyl-propionyl)-phenyl]-methyl}-phenyl)-2-methyl-propane-1-one 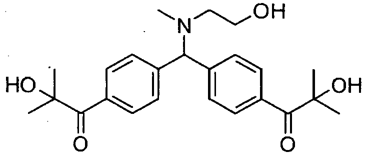
2-Hydroxy-1-(4-{{2-[2-(2-hydroxy-ethoxy)-ethoxy]-ethoxy}-[4-(2-hydroxy-2-methyl-propionyl)-phenyl]-methyl}-phenyl)-2-methyl-propan-1-one 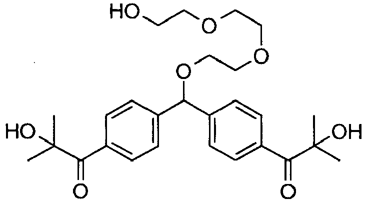
(6-{bis[4-(2-hydroxy-2-methyl-propionyl)-phenyl]-methoxycarbonylamino}-hexyl)-carbamic acid bis[4-(2-hydroxy-2-methyl-propionyl)-phenyl]-methyl ester 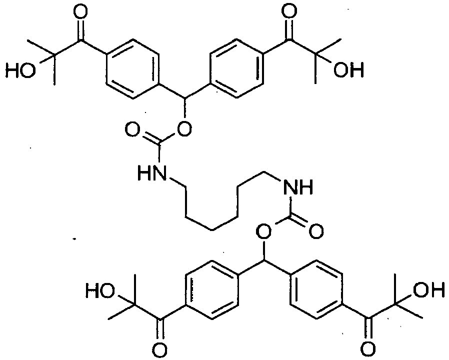
(8-{Bis-[4-(2-hydroxy-2-methyl-propionyl)-phenyl]-methoxycarbonylamino}-octyl)-carbamic acid bis-[4-(2-hydroxy-2-methyl-propionyl)-phenyl]-methyl ester 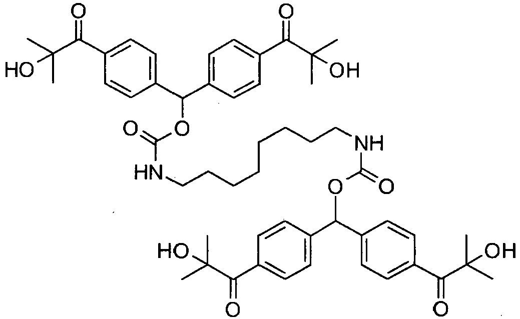
(12-{Bis-[4-(2-hydroxy-2-methyl-propionyl)-phenyl]-methoxycarbonylamino}-dodecyl)-carbamic acid bis-[4-(2-hydroxy-2-methyl-propionyl)-phenyl]-methyl ester 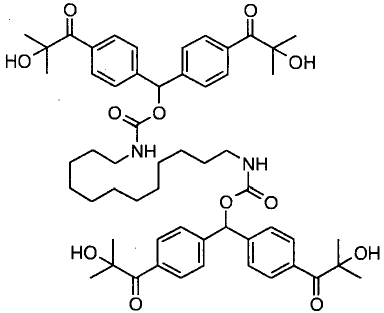
1-((4-{[2-(2-{bis[4-(2-hydroxy-2-methyl-propionyl)-phenyl]-methoxy}-ethoxy)-ethoxy]-[4-(2-hydroxy-2-methyl-propionyl)-phenyl]-methyl}-phenyl)-2-hydroxy-2-methyl-propan-1-one, diethylene glycol diether 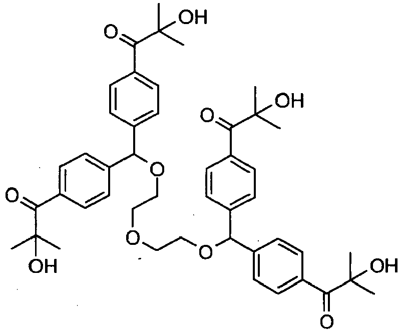
{1-[3-(1-{Bis-[4-(2-hydroxy-2-methyl-propionyl)-phenyl]-methoxycarbonylamino}-1-methyl-ethyl)-phenyl]-1-methyl-ethyl}-carbamic acid bis-[4-(2-hydroxy-2-methyl-propionyl)-phenyl]-methyl ester

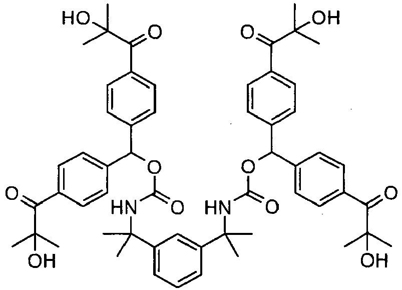

An example of an **alpha-alkoxyketone** is:
2,2-Dimethoxy-1,2-diphenylethan-1-one (IRGACURE^{®}651) and similar compounds as disclosed in the German patent application DE2232365

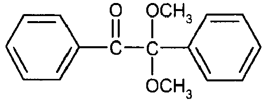

Also known as benzildimethylketals DBK or a blend of DBK with IRGACURE^{®}379

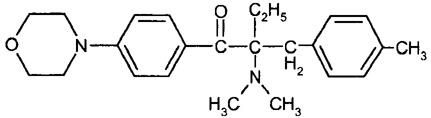

**Alpha-aminoketones** may be compounds as disclosed in the European patent application EP-0284561 for example compounds of the formula 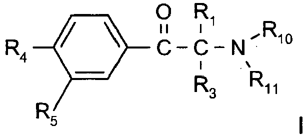 wherein
- **R₁** and **R₃**: independently of one another are hydrogen, C₁-C₆-alkyl, C₁-C₁₆-alkoxy or -O(CH₂CH₂O)₁₋₂₀-C₁-C₁₆-alkyl; or unsubstituted phenyl or benzyl; or phenyl or benzyl substituted by C₁-C₁₂-alkyl; or R₁ and R₃ together with the carbon atom to which they are attached form a cyclohexyl ring;
- **R₄**: is hydrogen, C₁-C₁₈-alkyl, C₁-C₁₈-alkoxy, -OCH₂CH₂-OH, -OCH₂CH₂-O-CO-CH=CH₂, -OCH₂CH₂-O-CO-C(CH₃)=CH₂, morpholino, SCH₃, a group 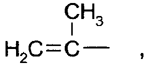 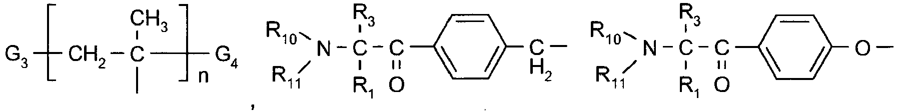
**n** is 2-10;
**G₃** and **G₄** independently of one another are hydrogen or methyl;
- **R₅**: is hydrogen or C₁-C₁₈-alkoxy,
- **R₁₀** and **R₁₁**: independently of one another are C₁-C₁₂-alkyl, C₂-C₄alkyl which is substituted by C₁-C₄alkoxy, --CN or --COO(C₁-C₄alkyl), allyl, cyclohexyl or benzyl, or **R₁₀** and **R₁₁** together are C₂-C₆alkylene, which can be interrupted by --O-- or --N(H)--, --N(C₁-C₄alkyl)-- -N-benzyl-.

Examples of **alpha-aminoketones** (AAK) are:
2-Methyl-1[4-(methylthio)phenyl]-2-morpholinopropan-1-one as disclosed in the European patent application EP-0284561 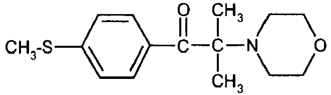
2-Benzyl-2-dimethylamino-1-(4-morpholinophenyl)-butanone-1 and similar compounds as disclosed in the European patent application EP-0284561 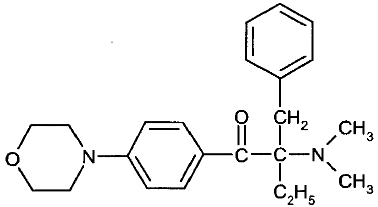
2-((4-Methylbenzyl)-2-(dimethylamino)-1-[4-(4-morpholinyl)phenyl]-1-butanone and similar compounds as disclosed in the European patent application EP-0284561 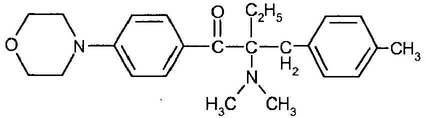 2-Benzyl-1-(3,4-dimethoxy-phenyl)-2-dimethylamino-butan-1-one as disclosed in the European patent application EP-0284561 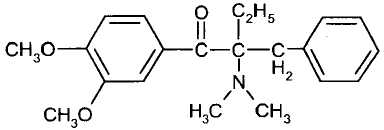
2-Benzyl-1-[4-(2-hydroxyethylamino)phenyl]-2-dimethylamino-1-butanone and similar compounds as disclosed in WO05/076074 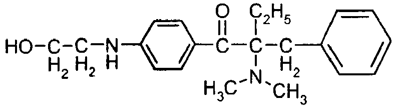
2-ethyl-1-[4-(2-hydroxyethyamino)phenyl]-2-dimethylamino-1-pent-4-en-1-one

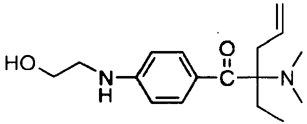

Irgacure- and Darocur-product are available from Ciba Specialty Chemicals Inc.

### 2. Benzphenones

Benzophenones may be of the formula 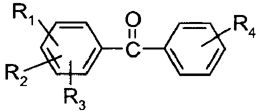 wherein
- **R₁, R₂** and **R₃**: independently of one another are hydrogen, C₁-C₄-alkyl, C₁-C₄-halogenalkyl, C₁-C₄-alkoxy, chlorine or N(C₁-C₄-alkyl)₂;
- **R₄**: is hydrogen, C₁-C₄-alkyl, C₁-C₄-halogenalkyl, phenyl, N(C₁-C₄-alkyl)₂, COOCH₃, 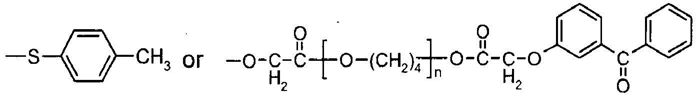 with n being 2-10.

Examples are:
Darocure BP 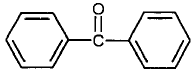
ESACURE TZT^{®} available from Lamberti, an eutectic mixture of 2,4,6-trimethylbenzophenone and 4-methylbenzophnone. 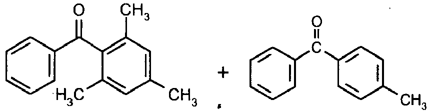
Michlers ketone 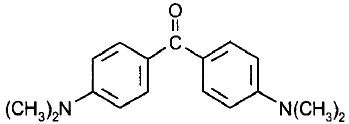
Speedcure MBB Lambson 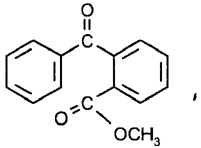
4-phenylbenzophenones and similar compounds as disclosed in WO04/074328, for example

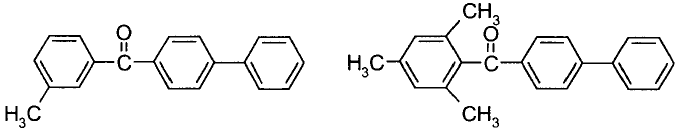

### 3. Acylphosphin oxides

**Mono- and bisacyphosphines are compounds of the formula** 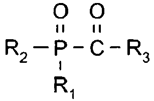 wherein
- **R₁** and **R₂**: independently of one another are unsubstituted C₁-C₂₀-alkyl, cyclohexyl, cyclopentyl, phenyl, naphthyl or biphenylyl; or C₁-C₂₀-alkyl, cyclohexyl, cyclopentyl, phenyl, naphthyl or biphenylyl substituted by halogen, C₁-C₁₂-alkyl, C₁-C₁₂-alkoxy, C₁-C₁₂alkylthio or NH₂ or N(C₁-C₆alkyl)₂, or **R₂ is-(CO)R₃,**
- **R₃**: is unsubstituted cyclohexyl, cyclopentyl, phenyl, naphthyl or biphenylyl or cyclohexyl, cyclopentyl, phenyl, naphthyl or biphenylyl substituted by halogen, C₁-C₄-alkyl and/or C₁-C₄-alkoxy; or R₃ is a 5- or 6-membered heterocyclic ring having an S atom or N atom;

Examples are:
bis(2,4,6-trimethylbenzoyl)-phenylphosphine oxide IRGACURE ^{®}819 and similar compounds as disclosed in EP0184095 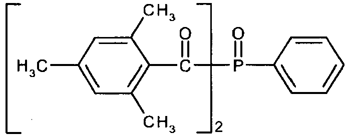
bis(2,6-dimethoxybenzoyl)-2,4,4-trimethyl pentylphosphine oxide 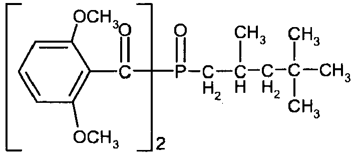
2,4,6-trimethylbenzoyl-diphenyl-phosphinoxide; Darocur^{®} TPO 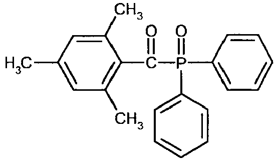
Lucirin LR 8893x BASF 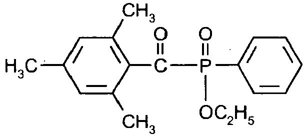
Bisacylphosphine oxides as disclosed in WO06/056541 for example compounds of the formula 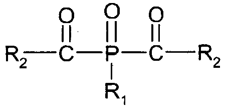 wherein
   R₂ is unsubstituted cyclohexyl, cyclopentyl, phenyl, naphthyl or biphenylyl or cyclohexyl, cyclopentyl, phenyl, naphthyl or biphenylyl substituted by halogen, C₁-C₄-alkyl and/or C₁-C₄-alkoxy; or R₂ is a 5- or 6-membered heterocyclic ring having an S atom or N atom;
   R₁ is phenyl, linear or branched C₁-C₈alkyl or C₂-C₁₈alkenyl or is linear or branched C₁-C₈alkyl or C₂-C₁₈alkenyl substituted by CN, trifluormethyl, oxiranyl, isoindole-1,3-dione, -O-C₁-C₁₈alkyl, -O-benzyl, -CO-phenyl, -CO-C₁-C₁₈alkyl, -OCO-C₁-C₁₈alkyl; -OCO-C₁-C₁₈alkenyl; -COO-C₁-C₁₈alkyl; -COO-C₁-C₁₈alkylene-phenyl, -COO-C₁-C₁₈alkylene-cycloalkyl, -COO-C₁-C₁₈alkylene-tetrahydrofuranyl, -COO-C₁-C₁₈alkylene-furanyl, -COO-cycloalkyl, -COO-C₁-C₁₈alkenyl; -COO-C₁-C₁₈alkenylene-phenyl; -COO-(CH₂)₂-₃-Cl, -COO-[(CH₂)₂-₃-O]₁₋₁₀-C₁-C₆alkyl; -COO-[(CH₂)₂-₃-O]₁₋₁₀-C₁-C₆-OH, -CO-CH₂-CO-C₁-C₁₈alkyl; -CO-CH₂-COO-C₁-C₁₈alkyl, -O-tetrahydropyranyl, bicyclo[2.2.1]hept-2-en-5-yl)-methyl, PO(OC₁-C₆alkyl)₂ and

Examples are:
[Methyl-(2,4,6-trimethyl-benzoyl)-phosphanyl]-(2,4,6-trimethyl-phenyl)-methanone 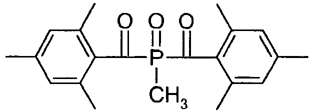
Acetic acid 3-[bis-(2,6-dimethoxy-benzoyl)-phosphinoyl]-propyl ester, 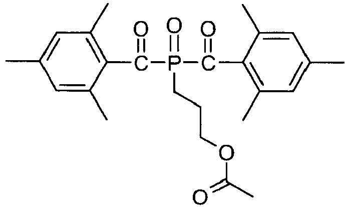
[bis-(2,4,6-trimethyl-benzoyl)-phosphanyl]-acetic acid ethyl ester

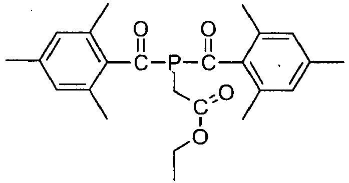

The residue R₁ may further, for example, be.

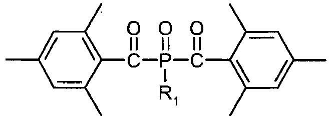

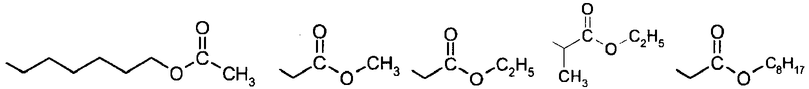

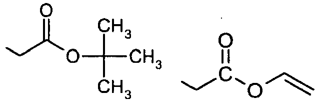

### 4. Phenylglyoxylates

Phenylglyoxylates may be compounds of the formula 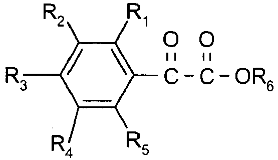
- **R₆**: is hydrogen, C₁-C₁₂-alkyl or a group

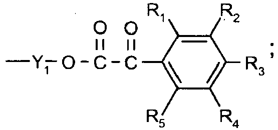

- **R₁, R₂, R₃, R₄** and **R₅**: independently of one another are hydrogen, unsubstituted C₁-C₁₂-alkyl or C₁-C₁₂-alkyl substituted by OH, C₁-C₄-alkoxy, phenyl, naphthyl, halogen or CN; and whereby the alkyl chain may be interrupted by one or more oxygen atoms; or R₁, R₂, R₃, R₄ and **R₅** independently of one another are C₁-C₄-alkoxy, C₁-C₄-alkythio or NR₅₂R₅₃; **R₅₂** and **R₅₃** independently of one another are hydrogen, unsubstituted C₁-C₁₂-alkyl or C₁-C₁₂-alkyl substituted by OH or SH whereby the alkyl chain may be interrupted by one to four oxygen atoms; or R₅₂ and R₅₃ independently of one another are C₂-C₁₂-alkenyl, cyclopentyl, cyclohexyl, benzyl or phenyl.
- **Y₁**: C₁-C₁₂-alkylene optionally interrupted by one or more oxygen.

Examples are oxo-phenyl-acetic acid 2-[2-(2-oxo-2-phenyl-acetoxy)-ethoxy]-ethyl ester and similar compounds as disclosed in WO03091287 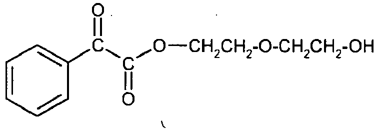 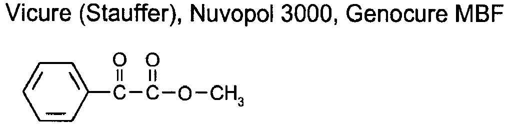 or oxo-phenyl-acetic acid 1-methyl-2-[2-(2-oxo-2-phenyl-acetoxy)-propoxy]-ethyl ester

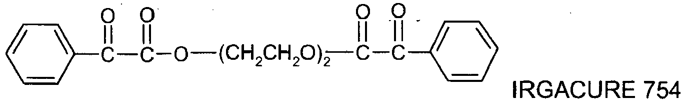

### 5. Isopropylthioxanthones

Examples are:
Lucirin LR 8771 (BASF) = Quantacure ITX 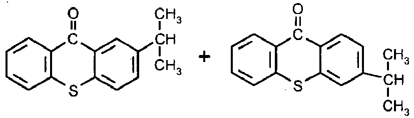
Kayacure DETX 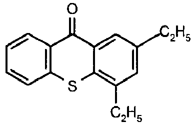
Quantacure CPTX

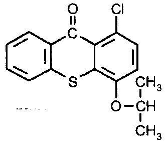

### 6. O-acyloximes

O-acyloximes as disclosed in US6596445 which are for example compounds of the formulae I, II, 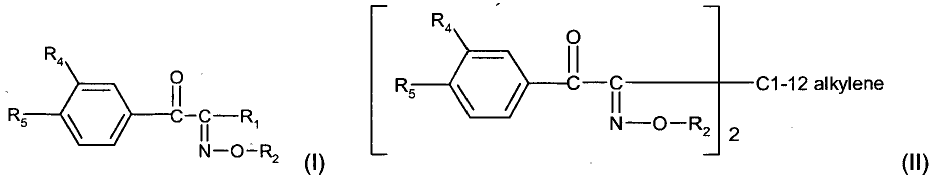
R₁ is phenyl, C₁-C₁₂alkyl;
**R₂** is C₂-C₄alkanoyl, or benzoyl which is unsubstituted or substituted by one or more C₁-C₄alkyl or halogen;
**R₄** and **R₅** independently of one another are hydrogen or a group OR₈, SR₉, or NR₁₀R₁₁;
**R₈** and **R₉** are C₁-C₄alkyl, phenyl or a group 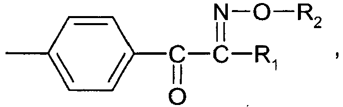
**R₁₀** and **R₁₁** are methyl or ethyl, or R₁₀ and R₁₁ together are C₂-C₆alkylene which is interrupted by -O-.

Examples are:
1,2-octanedione, 1-[4-(phenylthio)phenyl]-2-(O-benzoyloxime)

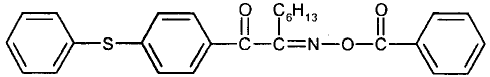

Oxime esters as disclosed in WO02/100903 for example compounds of the formula I 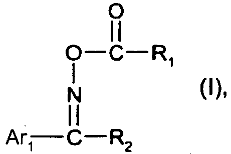
- **R₁**: is C₁-C₁₂alkyl or phenyl;
- **R₂**: is hydrogen, C₁-C₁₂alkyl, phenyl or C₂-C₁₂alkoxycarbonyl;
- **Ar₁**: is

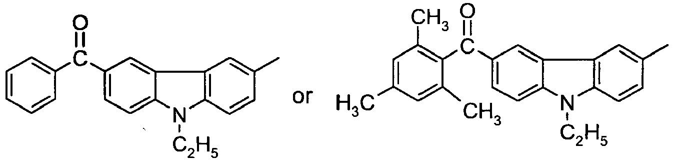

For Example
ethanone, 1-[9-ethyl-6-(2-methylbenzoyl)-9H-carbazol-3-yl]-1-(O-acetyloxime)

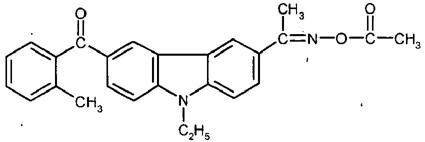

### 7. Aminobenzoates

Examples of Aminobenzoates are:
Ethyl-4-dimethylamino benzoate (Darocure EDB) 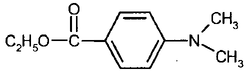
2-Ethylhexyl-4-dimethylamino benzoate (DarocureEHA)

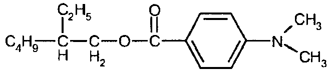

Especially suitable are alpha-hydroxyketones, bisacylphosphine oxides and phenylglyoxylates.

### 8. Other photoinitiators

Other photoinitiators that can be used for this approach have been described in K. Dietliker, Photoinitiators for Free Radical, Cationic and Anionic Photopolymerization, Vol III in the series Chemistry and Technology of UV and EB Formulation for Coating, Inks and Paints, 2nd ed.; John Wiley and Sons/SITA Technology Limited, New York/London 1998."

### 9. Latent acids and bases

In general, latent acids suitable as curing agents for coatings under thermal conditions and actinic radiation are sulfonic acid ester derivatives. EP 84515 and EP 89922 show α-sulfonyl-oxycarbonyl and β-sulfonyloxycarbonyl compounds as examples.

EP84515 and EP89922 disclose ß-sulfonyloxycarbonyl compounds such as, for example, 2-[(p-tolylsulfonyl)-oxy]-1-phenyl-1-propanone, 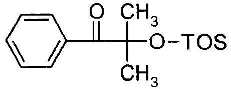 2-[(p-tolylsulfonyl)-oxy]-1-p-tolyl-1-propanone, 2-[(p-tolylsulfonyl)-oxy]-1-p-methylthiophenyl-1-propanone, 2-[(p-tolylsulfonyl)-oxy]-1,3-bis-phenyl-1 propanone, 2-[(p-tolylsulfonyl)-oxy]-3-phenyl-1-p-tolyl-1-propanone, 2-[(p-tolylsulfonyl)-oxy]-3-methyl-1-phenyl-1-butanone, 2-[(p-tolylsulfonyl)-oxy]-3-methyl-1-p-tolyl-1-butanone, 2-[(p-tolylsulfonyl)-oxy]-1-phenyl-1-dodecanone, 2-[(p-tolylsulfonyl)-oxy]-1-p-tolyl-1-dodecanone, 2-[(p-laurylphenylsulfonyl)-oxy]-3-methyl-1-p-methylthiophenyl-1-butanone and 2-[(p-tolylsulfonyl)-oxy]-tetral-1-one.

Oxime sulfonates with reactive groups for curing under high amount of short-wave light (US 4736055) and for long-wave radiation (US 6017675) have been reported, as well as alkylsulfonyl oximes for i-line resists (WO 98/10335), cyclic oxime sulfonates (WO 99/1429) and other cyclic acid derivatives (WO 00/26219).

Examples are alpha-(octylsulfonyloxyimino)-4-methoxybenzylcyanide as disclosed in WO98/10335 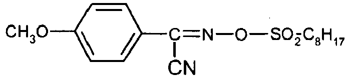 Compounds as disclosed in WO99/01429 of the formula 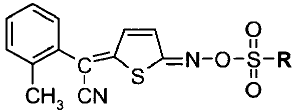 wherein R is methyl or C₂-C₈alkyl, camphoryl or 4-methylphenyl or a group of the formula

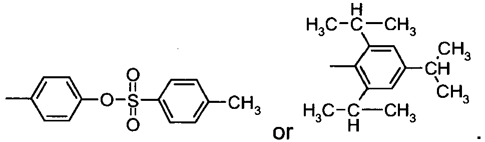

Further materials include styrene based unsaturated oxime derivatives as described in WO 00/10972 and CF₃-oxime sulfonates (GB 2348644, WO 02/25376).

A special class of materials is described as oxime acids with a carbonyl group in o-position of the phenyl ring (WO 02/98870) as for example 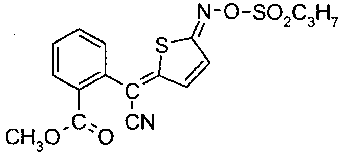 and oxime acids with CH₂CH₂-X or CH=CH₂ moieties in the sulfonyl group (WO 03/067332), for example 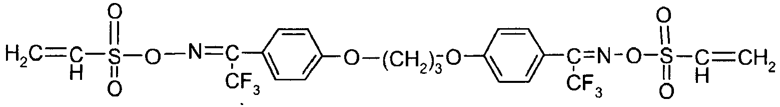 Haloalkyl oxime sulfonates with haloalkyl groups in the acid part as disclosed in WO 04/074242 such as, for example, ethanone, 1,1'-[1,3-propanediylbis(oxy-4,1-phenylene)]bis- [2,2,2-trifluoro-bis[O-(trifluoromethylsulfonyl)oxime] 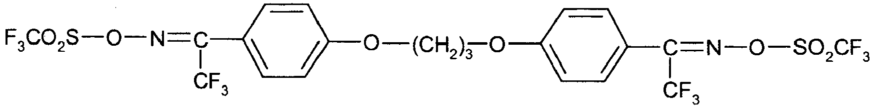 2-[2,2,3,3,4,4,5,5,6,6,7,7-dodecafluoro-1-(nonafluorobutylsulfonyloxyimino)-heptyl]-fluorene 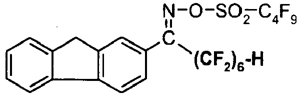 or compounds such as 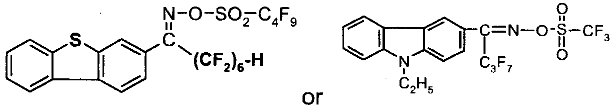 as disclosed in WO 04/074242.

Examples of photolatent amines as photoinitiators are amidines (WO 98/32756), amidines from α-aminoalkenes (WO 98/41524), and their corresponding benzylic derivates (WO 03/33500).

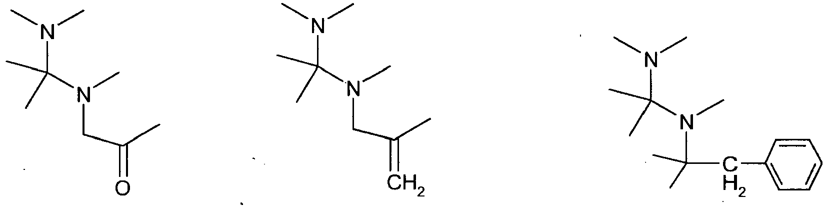

Examples are compounds of the formula 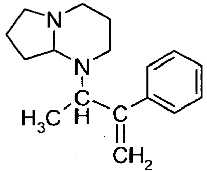 as disclosed in WO98/41524 or compounds of the formula 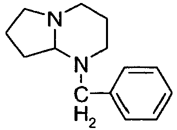 as disclosed in WO03/33500.

lodonium salts and ammonium salts of the above latent bases are employed in water based systems, however are less preferred for encapsulation due to their high water solubility.

### The ethylenically unsaturated monomer

For example the ethylenically unsaturated monomer is selected from the group consisting of styrene, substituted styrene, conjugated dienes, acrolein, vinyl acetate, vinylpyrrolidone, vinylimidazole, maleic anhydride, (alkyl)acrylic acid anhydrides, (alkyl)acrylic acid salts, (alkyl)acrylic esters, (alkyl)acrylonitriles, (alkyl)acrylamides, vinyl halides or vinylidene halides.

For instance the ethylenically unsaturated monomer is a compound of formula CH₂=C(**R**ₐ)-(C=**Z**)-**R_{b}**, wherein **Z** is O or S; **Rₐ** is hydrogen or C₁-C₄alkyl, **R_{b}** is NH₂, O⁻(Me⁺), glycidyl, unsubstituted C₁-C₁₈alkoxy, C₂-C₁₀₀alkoxy interrupted by at least one N and/or O atom, or hydroxy-substituted C₁-C₁₈alkoxy, unsubstituted C₁-C₁₈alkylamino, di(C₁-C₁₈alkyl)amino, hydroxy-substituted C₁-C₁₈alkylamino or hydroxy-substituted di(C₁-C₁₈alkyl)amino, -O-CH₂-CH₂-N(CH₃)₂ or -O-CH₂-CH₂-N⁺H(CH₃)₂ An⁻;
An⁻ is a anion of a monovalent organic or inorganic acid;
Me is a monovalent metal atom or the ammonium ion.

Preferably Rₐ is hydrogen or methyl, R_{b} is NH₂, glycidyl, unsubstituted or with hydroxy substituted C₁-C₄alkoxy, unsubstituted C₁-C₄alkylamino, di(C₁-C₄alkyl)amino, hydroxy-substituted C₁-C₄alkylamino or hydroxy-substituted di(C₁-C₄alkyl)amino; and Z is oxygen.

Examples of acids from which the anion An⁻ is derived are C₁-C₁₂carboxylic acids, organic sulfonic acids such as CF₃SO₃H or CH₃SO₃H, mineralic acids such as HCl, HBr or HI, oxo acids such as HClO₄ or complex acids such as HPF₆ or HBF₄.

Examples for R_{b} as C₂-C₁₀₀alkoxy interrupted by at least one O atom are of formula 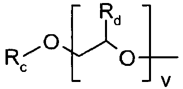 wherein R_{c} is C₁-C₂₅alkyl, phenyl or phenyl substituted by C₁-C₁₈alkyl, R_{d} is hydrogen or methyl and v is a number from 1 to 50. These monomers are for example derived from non ionic surfactants by acrylation of the corresponding alkoxylated alcohols or phenols. The repeating units may be derived from ethylene oxide, propylene oxide or mixtures of both.

Examples for specific ethylenically unsaturated monomers are styrene, iso-butylmethacrylate, cyclohexylmethacrylate, hydroxyethylmethacrylate, methylmethacrylate, benzyl-methacrylate, vinyl toluene, n-butylacrylate, tert-butylacrylate, methylacrylate, ethylacrylate, propylacrylate, hexylacrylate or hydroxyethylacrylate or mixtures thereof.

A particular suitable monomer mixture is a mixture of hydroxyethylmethacrylate, methylmethacrylate, cyclohexylmethacrylate, vinyl toluene, methylmethacrylate, iso-butylmethacrylate.

Further examples of suitable acrylate or methacrylate monomers are given below. 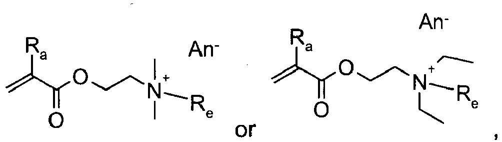 wherein An⁻ and Rₐ have the meaning as defined above and Rₑ is methyl or benzyl. An⁻ is preferably Cl⁻, Br - or -O₃S-CH₃.

Further acrylate monomers are:

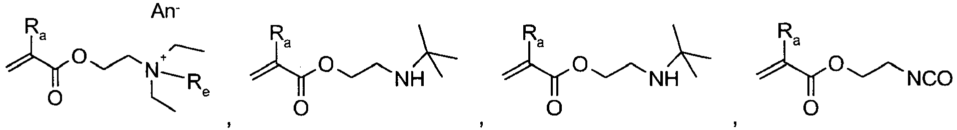

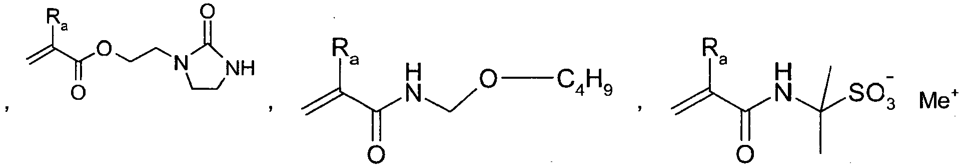

Examples for suitable monomers other than acrylates are:

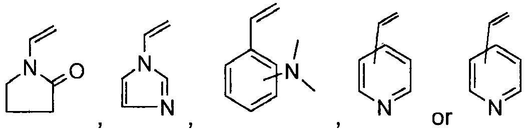

Acrylic acid esters and methacrylic acid esters are typically C₁-C₁₈alkyl esters.

Preferred is a concentrated aqueous polymer dispersion wherein the ethylenically unsaturated monomer is selected from the group consisting of C₁-C₁₈acrylates, C₁-C₁₈methacrylates, acrylic acid, (meth)acrylic acid, styrene, vinyltoluene, hydroxy-functional acrylates or (meth)acrylates, acrylates or (meth)acrylates derived from alkoxylated alcohols and multifunctional acrylates or (meth)acrylates or mixtures thereof.

Most preferred: C₁-C₁₈-(meth)acrylates like methyl(meth)acrylate, ethyl(meth)acrylate butyl-(meth)acrylate, iso-butyl(meth)acrylate, 2-ethylhexyl(meth)acrylate, stearyl(meth)acrylate, cyclohexyl(meth)acrylate, benzylmethacrylate, (meth)acrylic acid, styrene, vinyltoluene, hydroxy-functional (meth)acrylates like 2-hydroxyethyl(meth)acrylate, (meth)acrylates derived from alkoxylated alcohols, multifunctional (meth)acrylates like butandiol-di(meth)-acrylate or ethylene glycol-di(meth)acrylate.

In a specific embodiment the concentrated aqueous polymer dispersion is prepared from a mixture of at least two of the above monomers and at least one monomer which is bifunctional, so that a crosslinked polymer is obtained. The amount of bifunctional monomer is for example from 0.5 to 20 weight%, based on the weight of the sum of monomers.

Typical examples for bifunctional monomers are divinyl-benzene, ethylene glycol diacrylate, butylene glycol diacrylate or diethylene glycol diacrylate.

The monomers or monomer mixtures have preferably a low water solubility, which is below 5%, more preferred below 0.5% and most preferred below 0.1 % by weight.

**A further aspect of the invention** is a process for the preparation of a concentrated aqueous polymer dispersion with an average particle size of less than 1000 nm comprising the step
polymerizing at least one ethylenically unsaturated monomer in the presence of a photoinitiator and/or a photolatent catalyst by heterophase radical polymerization; wherein the weight ratio of the photoinitiator and/or a photolatent catalyst to the polymer carrier formed from the ethylenically unsaturated monomer is greater than 35 parts of photoinitiator and/or a photolatent catalyst per 100 parts of polymer carrier. Preferably the weight ratio of the photoinitiator and / or photolatent catalyst to the polymer carrier is equal or greater than 50 parts of photoinitiator and / or photolatent catalyst per 100 parts of polymer carrier.

In a specific embodiment of the invention the process for the preparation of a concentrated aqueous polymer dispersion comprises the steps
a) dissolving, emulsifying or dispersing a photoinitiator and/or photolatent catalyst in at least one ethylenically unsaturated monomer;
b) preparing a conventional oil in water emulsion of said photoinitiator and/or photolatent catalyst dissolved, emulsified or dispersed in at least one ethylenically unsaturated monomer;
c) homogenizing the conventional emulsion to a mini-emulsion wherein the droplets of the organic phase have an average diameter below 1000 nm;
d) polymerizing the mini-emulsion by adding a polymerization initiator;
wherein the weight ratio of the photoinitiator and / or photolatent catalyst to the polymer carrier is greater than 35 parts of photoinitiator and / or photolatent catalyst per 100 parts of polymer carrier, wherein the photoinitiator is selected from alpha-hydroxyketones, bisacylphosphine oxides or phenylglyoxylates.

Preferably the weight ratio of the photoinitiator and / or photolatent catalyst to the polymer carrier is equal or greater than 5 parts of photoinitiator and / or photolatent catalyst per 100 parts of polymer carrier.

In step b) preferably a non-ionic, cationic or anionic surfactant is additionally present.

In general anionic and non-ionic surfactants are preferred.

In another specific embodiment of this process, organic solvents may be added to the mixture of photoinitiator and/or photolatent catalyst, monomer and water in order to support the formation of a stable pre-emulsion or pre-dispersion. Such solvents may preferably dissolve in the monomers and or help to dissolve the photoinitiator. Such solvents may be selected from common organic solvents like aliphatic or aromatic hydrocarbons, ethers, esters, alcohols, glycols, glycolethers, glycolether-esters like methoxypropylacetate, alkoxylates like butyldiglycol or poly or oligoethyleneoxides or poly or oligopropyleneoxides, amide solvent like NMP or DMF. The solvent is preferably selected from solvents which have common use in the coatings industry. The solvent may typically be used on a level of up to 200% wt relative to the photoinitiator, preferably up to 100%, most preferably of up to 50% wt relative to the photoinitiator
Optionally other water miscible solvents may be present usually less than 10% by weight based on the water content. Exemplary cosolvents useful in the present invention may be selected from the group consisting of aliphatic alcohols, glycols, ethers, glycol ethers, glycol esters, pyrrolidines, N-alkyl pyrrolidinones, N-alkyl pyrrolidones, polyethylene glycols, polypropylene glycols, amides, carboxylic acids and salts thereof, esters, organosulfides, sulfoxides, sulfones, alcohol derivatives, hydroxyether derivatives such as butyl carbitol or cellosolve, amino alcohols, ketones, and the like, as well as derivatives thereof and mixtures thereof. Specific examples include methanol, ethanol, propanol, dioxane, ethylene glycol, propylene glycol, diethylene glycol, glycerol, dipropylene glycol, tetrahydrofuran, and other water-soluble or water-miscible materials, and mixtures thereof.

Preferred are water, water-alcohol mixtures, water ethylene glycol or propylene glycol mixtures, water acetone, water tetrahydrofurane, or water dimethylformamide mixtures. Depending on the targeted application, the solvent may stay in the end product or may be removed form the aqueous polymer dispersion, e.g. by distillation.

Suitable surfactants or surface active compounds, which may be added are known in the art. The amounts typically used range from 0.01% by weight to 10% by weight, based on the monomer or monomers.

Typical surfactants useful in the present invention are of nonionic, cationic or anionic type.

Examples for anionic surfactants are alkali and ammonium salts of C₁₂-C₁₈alkylsulfonic acid, dialkyl esters of succinic acid or sulfuric acid halfesters of ethoxylated alkanoles. These compounds are known for example from US 4 269 749 and largely items of commerce, such as under the trade name Dowfax® 2A1 (Dow Chemical Company).

Nonionic surfactants are for example aliphatic or araliphatic compounds such as ethoxylated phenols (mono, di, tri) with an ethoxylation degree of 3 to 50 and alkyl groups in the range from C₄-C₉, ethoxylated long chain alcohols or polyethyleneoxide/polypropyleneoxide block copolymers.

Disponil FES 32 is a fatty alcohol polyglycolether sulfate Na salt.

Furthermore protective colloids such as polyvinylalcohols, starch, cellulose derivatives or copolymers containing vinylpyrrolidone may be added to form a conventional oil in water emulsion according to step b). Further examples are given in "Houben-Weyl, Methoden der Organischen Chemie, Band XIV/1, Makromolekulare Stoffe, G. Thieme Verlag Stuttgart 1961, 411-420".

The homogenization step c) is usually carried out by applying mechanical agitation (rotor/stator disperser) followed by using high force dispersion devices like for example a ultrasonic sound equipment (J. Dispersion Sci. Technology 2002, 23(1-3), 333-349) or a high pressure homogenizer (APV Gaulin homogenizer; Microfluidizer) The emulsification/homogenization can be carried out continuously or batchwise. Apparatus for this purpose are known in the art. This is for example described in US 5,108,654.

The polymerization step d) is carried out by adding a free radical polymerization initiator.

Preferably the free radical initiator is present in an amount of from 0.01 weight% to 20 weight%, more preferably from 0.1 weight% to 10 weight% and most preferably from 0.2 weight% to 5 weight-%, based on the monomer or monomer mixture.

The polymerization initiator may be added batchwise or continuously to the reaction mixture.

Preferably the free radical initiator of component d) is a bis-azo compound, a peroxide or a hydroperoxide.

Specific preferred radical sources are 2,2'-azobisisobutyronitrile, 2,2'-azobis(2-methyl-butyro-nitrile), 2,2'-azobis(2,4-dimethylvaleronitrile), 2,2'-azobis(4-methoxy-2,4-dimethylvalero-nitrile), 1,1'-azobis(1-cyclohexanecarbonitrile), 2,2'-azobis(isobutyramide) dihydrate, 2-phenylazo-2,4-dimethyl-4-methoxyvaleronitrile, dimethyl-2,2'-azobisisobutyrate, 2-(carb-amoylazo)isobutyronitrile, 2,2'-azobis(2,4,4-trimethylpentane), 2,2'-azobis(2-methylpropane), 2,2'-azobis(N,N'-dimethyleneisobutyramidine), free base or hydrochloride, 2,2'-azobis(2-amidinopropane), free base or hydrochloride, 2,2'-azobis{2-methyl-N-[1,1-bis(hydroxy-methyl)ethyl]propionamide} or 2,2'-azobis{2-methyl-N-[1,1-bis(hydroxymethyl)-2-hydroxy-ethyl]propionamide; acetyl cyclohexane sulphonyl peroxide, diisopropyl peroxy dicarbonate, t-amyl perneodecanoate, t-butyl perneodecanoate, t-butyl perpivalate, t-amylperpivalate, bis(2,4-dichlorobenzoyl)peroxide, diisononanoyl peroxide, didecanoyl peroxide, dioctanoyl peroxide, dilauroyl peroxide, bis (2-methylbenzoyl) peroxide, disuccinic acid peroxide, diacetyl peroxide, dibenzoyl peroxide, t-butyl per 2-ethylhexanoate, bis-(4-chlorobenzoyl)-peroxide, t-butyl perisobutyrate, t-butyl permaleinate, 1,1-bis(t-butylperoxy)3,5,5-trimethyl-cyclohexane, 1,1-bis(t-butylperoxy)cyclohexane, t-butyl peroxy isopropyl carbonate, t-butyl perisononaoate, 2,5-dimethylhexane 2,5-dibenzoate, t-butyl peracetate, t-amyl perbenzoate, t-butyl perbenzoate, 2,2-bis (t-butylperoxy) butane, 2,2 bis (t-butylperoxy) propane, dicumyl peroxide, 2,5-dimethylhexane-2,5-di-t-butylperoxide, 3-t-butylperoxy 3-phenylphthalide, di-t-amyl peroxide, α, α'-bis(t-butylperoxy isopropyl) benzene, 3,5-bis (t-butylperoxy)3,5-dimethyl 1,2-dioxolane, di-t-butyl peroxide, 2,5-dimethylhexyne-2,5-di-t-butylperoxide, 3,3,6,6,9,9-hexamethyl 1,2,4,5-tetraoxa cyclononane, p-menthane hydroperoxide, pinane hydroperoxide, diisopropylbenzene mono-α-hydroperoxide, cumene hydroperoxide or t-butyl hydroperoxide.

It is also possible to use combinations of Fe-compounds or Co-compounds with peroxo salts or salts of bisulfites or hydrosulfites or combinations of inorganic or organic peroxo compounds with reducing agents or amino compounds. These combinations are known as redox systems.

The polymerization temperature depends on the initiator used. Usually the polymerization temperature is in the range of 5° C to 95° C and preferably from 30° C to 90°, more preferable at room temperature.
If pressure is applied the temperature can raise up to 120° C, however, polymerization under normal pressure is the usual process.

In another embodiment it is also possible to add a preformed polymer to the monomer/photoinitiator solution of step a) and/ or steps b)
This polymer may preferentially be soluble in the monomer and may support the process steps a), and/or b) i.e. may support the formation of a nanodisperse emulsion of PI and monomer in water.

Surprisingly it has been found that after polymerization has been completed, the volatile components, water mainly, can be removed without agglomeration of the particles. The polymer particles can therefore readily be re-dispersed, if desired.

Vaporization of the volatile components can be carried out using standard methods, such as for example spray drying.

Consequently **another aspect of the invention is** a process for preparing a polymer powder by preparing a concentrated aqueous polymer dispersion as described above followed by vaporizing the volatile components of the concentrated aqueous polymer dispersion and a polymer powder obtainable by said process.

The aqueous polymer dispersion containing high concentration of photoinitiators and/or photolatent catalysts as well as corresponding polymer powders containing highly concentrated photoinitiators and/or photolatent catalysts may be used, for example, in aqueous or non-aqueous formulations, coatings, inks, adhesives.

As such, the polymer powder can also be incorporated into solvent based coatings and ink systems, when water is detrimental to the performance of the film (e.g. polyurethanes)

The aqueous polymer dispersion containing high concentration of photoinitiators and/or photolatent catalysts as well as corresponding polymer powders containing highly concentrated photoinitiators and/or photolatent catalysts may also be used in formulations for electronic materials, e.g. for microlithography in resist manufacture or for color filter resists for flat panel displays.

The colour-binding coatings can contain further additives, for example antioxidants, light stabilizers, viscosity improvers, brighteners, dispersants, defoamers, levelling agents, biocides and/or antistats.

The coating is usually prepared as follows:
The water-soluble components, for example the binder, are dissolved in water and mixed.
The solid components, for example fillers and other additives as already described, are dispersed in this aqueous medium. Dispersion is advantageously brought about with the aid of equipment such as ultrasonic devices, turbine agitators, homogenizers, colloid mills, bead mills, sand mills, high-speed stirrers and the like. The polymer dispersions of this invention are stirred in/ post added under low or medium shear force into the coatings. A particular advantage of the instant polymer dispersions is their ease of incorporation into the coating and their storage stability.

### Examples

### Synthesis of concentrated aqueous product forms of photoinitiators via mini-emulsion polymerization

Water-borne product forms of the following hydrophobic photoinitiators were synthesized:

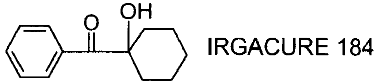

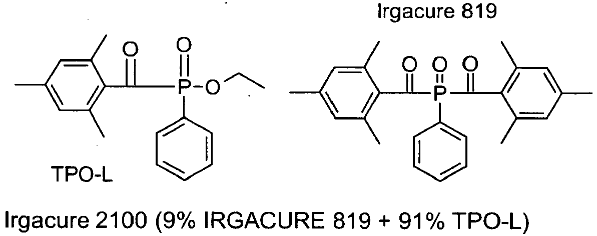

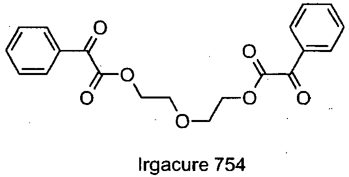

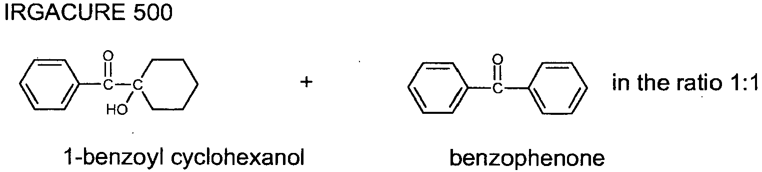

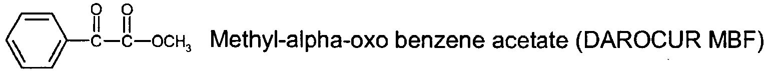

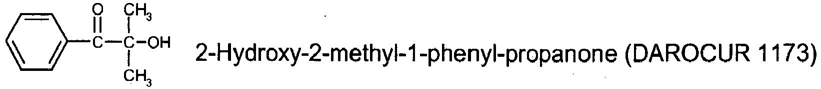

### Example 1

For the preparation of a stable oil/water emulsion 19.2 g of **Irgacure 184** was dissolved in 17.7 g of methyl methacrylate (MMA), 1.5 g of stearyl methacrylate (SMA) and 0.035 g of AIBN. The oil phase was added dropwise to a stirred solution of 1.6 g sodium dodecyl-sulphate in 54 g of deionised water. After stirring for 30 min and ultrasound treatment a kinetic stable emulsion of an average droplet size below 250 nm was obtained.

0.035 g of potassium persulfate in 2.5 g of water was added to the emulsion. The emulsion was heated to 80 °C. The reaction mixture was continuously stirred by a mechanical stirrer and was maintained at 80 °C for four hours, then cooled to RT and filtered via a 20 µm filter. The resulting particles have a particle size D_{INT} of 120 nm. The final active content of the dispersion is 19 wt%, the solid content is 40 wt%.

Dynamic light scattering (DLS, 90° scattering angle, Nicomp Model 380, Particle Sizing System, Santa Barbara, CA, USA) was used to determine the mean intensity diameter (D_{INT}).

### Example 2

For the preparation of a stable oil/water emulsion 20 g **Irgacure 184** was dissolved in 4.95 g of methyl methacrylate (MMA), 1.5 g stearyl methacrylate (SMA), 5.3 g of isobutylmeth-acrylate (iBMA), 2.7 g of vinyltoluene, 2.7 g of cyclohexylmethacrylate (CHMA), 1.9 g of hydroxyethylmethacrlyte, 0.057 g of butandioldiacrylate (BDDA) and 0.27 g of tert-butylperoxybenzoate. The oil phase was added dropwise to a stirred solution of 5.0 g Disponil FES 32 (31 wt% active, Cognis Deutschland GmbH&Co.KG) in 55.56 g deionised water. After stirring for 30 min and min and ultrasound treatment a kinetic stable emulsion of an average droplet size below 250 nm was obtained.

The emulsion was heated up to 85 ° was continuously stirred by a mechanical stirrer and was maintained at 85-90 °C for six hours, then cooled to RT and filtered via a 20 µm filter. The resulting particles have a particle size D_{INT} of 90 nm. The final active content of the dispersion is 20 wt% and the solid content is 40 wt%.

### Example 3

For the preparation of a stable oil/water emulsion 19.2 g of **Irgacure 2100** was dissolved in 17.7 g of methyl methacrylate (MMA) and 1.5 g of stearyl methacrylate (SMA). The oil phase was added dropwise to a stirred solution of 5.2 g Disponil FES 32 (31 wt% active, Cognis Deutschland GmbH&Co.KG) in 54 g deionised water. After stirring for 30 min and ultrasound treatment a kinetic stable emulsion of an average droplet size below 250 nm was obtained. The emulsion was heated up to 55 °C and the initiator H₂O₂ (0.83 ml, 35%) was added.
The emulsion was continuously stirred by a mechanical stirrer and heated to 40 °C, followed by addition of 0.19 g of Rongalit, dissolved in 2.5 g of water over a period of 1 hour.
The reaction mixture was subsequently stirred at 60 °C for one hour, then cooled to RT and filtered via a 20 µm filter. The resulting particles have a particle size D_{INT} of 98 nm. The final active content of the dispersion is 19 wt%, the solid content is 40 wt%.

### Example 4

For the preparation of a stable oil/water emulsion 76.8 g of **Irgacure 2100** was dissolved in 70.7 g of methyl methacrylate (MMA) and 6.1 g of stearyl methacrylate (SMA). Then AIBN (0.15 g) was dissolved in the oil phase. The oil phase was added dropwise to a stirred solution of 20.6 g Disponil FES 32 (31 wt% active, Cognis Deutschland GmbH&Co.KG) in 215.5 g of deionised water. After stirring for 30 min and ultrasound treatment for 3 minutes, a kinetic stable emulsion of an average droplet size below 200 nm was obtained.

The emulsion was heated up to 80 °C and potassium persulfate (0.15 g), dissolved in 10 ml of water, was added at 80 °C.
The emulsion was continuously stirred by a mechanical stirrer and maintained at 80-85 °C over a period of 4 hours, then cooled to RT and filtered via a 20 µm filter. The resulting particles have a particle size D_{INT} of 114 nm. The final active content of the dispersion is 19.2 wt%, the solid content is 39.6 wt%.

### Example 5

For the preparation of a stable oil/water emulsion 30.0 g of **Irgacure 754** was dissolved in 78.3 g of methyl methacrylate (MMA), 6.96 g of stearyl methacrylate (SMA), 1.74 g of methacrylic acid (MAA) and 0.26 g of butandiol diacrylate. The oil phase was added dropwise to a stirred solution of 15.10 g sodium dodecylsulphate in 145.9 g of deionised water. After stirring for 30 min and ultrasound treatment a kinetic stable emulsion of an average droplet size below 250 nm was obtained.

0.035 g of t-butyl hydroperoxide in 10 g of water was added to the emulsion. The emulsion was heated to 40 °C. To this mixture was added 0.87 g of Rongalit in 10 g of water at 40 °C for 1 hour. The reaction mixture was continuously stirred by a mechanical stirrer and was maintained at 60 °C for 1 hour, then cooled to RT and filtered via a 20 µm filter. The resulting particles have a particle size D_{INT} of 71 nm. The final active content of the dispersion is 19 wt%, the solid content is 40 wt%.

### Example 6

For the preparation of a stable oil/water emulsion 60.0 g of an alpha hydroxyketone of the formula. 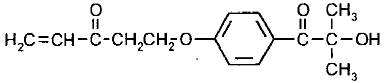 was dissolved in 51.3 g of methyl meth¬acrylate (MMA), 4.56 g of stearyl methacrylate (SMA), 1.41 g of methacrylic acid (MAA) and 0.17 g of butandiol diacrylate. The oil phase was added dropwise to a stirred solution of 15.10 g sodium dodecylsulphate in 146.49 g of deionised water. After stirring for 30 min and ultrasound treatment a kinetic stable emulsion of an average droplet size below 222 nm was obtained.

0.41 g of t-butyl hydroperoxide in 10 g of water was added to the emulsion. The emulsion was heated to 40 °C. To this mixture was added 0.57 g of Rongalit in 10 g of water at 40 °C for 1 hour. The reaction mixture was continuously stirred by a mechanical stirrer and was maintained at 60 °C for 1 hour, then cooled to RT and filtered via a 20 µm filter. The resulting particles have a particle size DINT of 95.4 nm. The final active content of the dispersion is 20 wt%, the solid content is 39 wt%.

### Example 7

For the preparation of a stable oil/water emulsion 60 g of mixture of **Irgacure 500** and **Irgacure 819** was dissolved in 30.0 g of methyl methacrylate (MMA), 22.5 g of stylene, 22.5 g of vinyltoluene and 0.23 g of butandiol diacrylate. The oil phase was added dropwise to a stirred solution of 17.42 g Disponil FES 32 (31 wt% active, Cognis Deutschland GmbH&Co.KG) in 125.8 g of deionised water. After stirring for 30 min and ultrasound treatment a kinetic stable emulsion of an average droplet size below 295.6 nm was obtained.

0.54 g of t-butyl hydroperoxide in 10 g of water was added to the emulsion. The emulsion was heated to 40 °C. To this mixture was added 0.75 g of Rongalit in 10 g of water at 40 °C for 1 hour. The reaction mixture was continuously stirred by a mechanical stirrer and was maintained at 60 °C for 1 hour, then cooled to RT and filtered via a 20 µm filter. The resulting particles have a particle size D_{INT} of 102.6 nm. The final active content of the dispersion is 20.0 wt%, the solid content is 45.0 wt%.

### Example 8

For the preparation of a stable oil/water emulsion 60 g of mixture of **Irgacure 819** and **Darocure 1173** was dissolved in 30.0 g of methyl methacrylate (MMA), 22.5 g of stylene, 22.5 g of vinyltoluene and 2.25 g of butandiol diacrylate. The oil phase was added dropwise to a stirred solution of 17.42 g Disponil FES 32 (31 wt% active, Cognis Deutschland GmbH&Co.KG) in 123.8 g of deionised water. After stirring for 30 min and ultrasound treatment a kinetic stable emulsion of an average droplet size below 279.1 nm was obtained.

0.54 g of t-butyl hydroperoxide in 10 g of water was added to the emulsion. The emulsion was heated to 40 °C. To this mixture was added 0.75 g of Rongalit in 10 g of water at 40 °C for 1 hour. The reaction mixture was continuously stirred by a mechanical stirrer and was maintained at 60 °C for 1 hour, then cooled to RT and filtered via a 20 µm filter. The resulting particles have a particle size D_{INT} of 105.1 nm. The final active content of the dispersion is 20.0 wt%, the solid content is 45.0 wt%.

### Example 9

For the preparation of a stable oil/water emulsion 80 g of mixture of **Irgacure 2100** and **Irgacure 819** was dissolved in 38.4 g of methyl methacrylate (MMA), 28.8 g of stylene, 28.8 g of vinyltoluene and 0.29 g of butandiol diacrylate. The oil phase was added dropwise to a stirred solution of 22.71 g Disponil FES 32 (31 wt% active, Cognis Deutschland GmbH&Co.KG) in 179 g of deionised water. After stirring for 30 min and ultrasound treatment a kinetic stable emulsion of an average droplet size below 341.0 nm was obtained.

0.69 g of t-butyl hydroperoxide in 10 g of water was added to the emulsion. The emulsion was heated to 40 °C. To this mixture was added 0.96 g of Rongalit in 10 g of water at 40 °C for 1 hour. The reaction mixture was continuously stirred by a mechanical stirrer and was maintained at 60 °C for 1 hour, then cooled to RT and filtered via a 20 µm filter. The resulting particles have a particle size D_{INT} of 84.5 nm. The final active content of the dispersion is 20.0 wt%, the solid content is 44.0 wt%.

### Example 10

For the preparation of a stable oil/water emulsion 80 g **Darocure MBF** was dissolved in 20.8 g of methyl methacrylate (MMA), 6.32 g stearyl methacrylate (SMA), 22.3 g of isobutylmethacrylate (iBMA), 11.3 g of vinyltoluene, 11.3 g of cyclohexylmethacrylate (CHMA), 8.0 g of hydroxyethylmethacrlyte, 0.4 g of butandioldiacrylate (BDDA) and 0.8 g of tert-butylperoxybenzoate. The oil phase was added dropwise to a stirred solution of 20.65 g Disponil FES 32 (31 wt% active, Cognis Deutschland GmbH&Co.KG) in 205.51 g deionised water. After stirring for 10 min high pressure homogenizing treatment, a kinetic stable emulsion of an average droplet size below 168.7 nm was obtained.
The emulsion was heated to 40 °C. To this mixture was added 0.80 g of Rongalit in 10 g of water at 40 °C for 1 hour. The reaction mixture was continuously stirred by a mechanical stirrer and was maintained at 60 °C for 1 hour, then cooled to RT and filtered via a 20 µm filter. The resulting particles have a particle size D_{INT} of 88.0 nm. The final active content of the dispersion is 20.0 wt%, the solid content is 40.0 wt%.

### Application results

### Example A1:

A clear UV curable water-borne coating was formulated by mixing the ingredients upon stirring (see table below).

| | |
|---|---|
| | |
| Bayhydrol VP LS 2282 (aliphatic polyurethane dispersion), Bayer | 97.3 |
| Borchigel L 75 N (thickener), Borchers | 0.3 |
| Byk 347 (wetting agent), Byk Chemie | 0.4 |

The prepared formulation was added to a dispersion according to Example 1 (1% active on total formulation) and stirred at low shear rate for 60 minutes at room temperature.

The coating was applied with a 100 µm slit coater to white chip boards, dried 10 minutes at 60°C and cured with two medium pressure mercury vapor lamps (2 x 80W/cm) at 5m/min for determining pendulum hardness and yellowing (measurement of L*a*b* according to DIN 6174) and performing KMnO4-test. For that 1% aqueous solution of potassium permanganate is put on the coating surface. After one minute the solution is poured off and cleaned with water. After drying, the color difference before and after exposure is determined. Low DE* value indicates that double bond conversion in the coating surface is nearly completed.

| | Pendulum hardness (s) | b* | DE* (KMnO₄-test) |
|---|---|---|---|
| Without photoinitiator | 105 | 5.9 | 23.1 |
| 5% dispersion according to **Ex. 1** | 180 | 6.8 | 5.5 |

### Example A2:

A white pigmented UV curable water-borne coating was formulated. The white paste was prepared by dispersing with glass beads. The ingredients and the white paste were mixed upon stirring (see table below).

White paste:

| | |
|---|---|
| Kronos 2310 (titanium dioxide), Kronos | 70.0 |
| Optigel SH (thickener), Sued-Chemie | 0.2 |
| Water | 26.0 |
| EFKA 2550 (defoamer), Ciba | 0.3 |
| EFKA 4550 (dispersant), Ciba | 3.5 |

White pigmented coating:

| | |
|---|---|
| Bayhydrol VP LS 2282 (aliphatic polyurethane dispersion), Bayer | 84.7 |
| White paste (70% titanium dioxide) | 14.4 |
| Borchigel L 75 N (thickener), Borchers | 0.6 |
| Byk 347 (wetting agent), Byk-Chemie | 0.3 |
| Byk 024 (defoamer), Byk-Chemie | 0.2 |

To the prepared formulation a dispersion according to Ex. 4 (1 % active on total formulation) was added and stirred at low shear rate for 30 minutes at room temperature.

The coating was applied with a 100 µm slit coater to white chip boards, dried 10 minutes at 60°C and cured with two medium pressure mercury vapor lamps (2 x 80W/cm) at 5m/min for determining pendulum hardness.

| | Pendulum hardness (s) |
|---|---|
| Without photoinitiator | 15 |
| 1% IRGACURE 500 | 38 |
| 2.5% of a dispersion according to **Ex. 4** + 1 % IRGACURE 500 | 77 |

### Example A3:

A white pigmented UV curable water-borne coating was formulated. The white paste was prepared by dispersing with glass beads. The ingredients and the white paste were mixed upon stirring (see table below).

White pigmented coating:

| | |
|---|---|
| Alberdingk Lux 399 (aliphatic polyurethane/acrylate copolymer), Alberdingk Boley | 79.1 |
| White paste (70% titanium dioxide) | 20.0 |
| Borchigel L 75 N (thickener), Borchers | 0.6 |
| Byk 347 (wetting agent), Byk-Chemie | 0.3 |
| Byk 024 (defoamer), Byk-Chemie | 0.2 |

To the prepared formulation a dispersion according to Ex. 4 (1 % active on total formulation) was added and stirred at low shear rate for 30 minutes at room temperature.

The coating was applied with a 100 µm slit coater to white chip boards, dried 10 minutes at 60°C and cured with two medium pressure mercury vapor lamps (2 x 80W/cm) at 5m/min for determining pendulum hardness.

| | Pendulum hardness (s) |
|---|---|
| Without photoinitiator | 19 |
| 1% IRGACURE 500 | 22 |
| 2.5% of a dispersion according to **Ex. 4** + 1 % IRGACURE 500 | 79 |
| | |

### Example A4:

A clear UV curable water-borne coating was formulated by mixing the ingredients upon stirring (see table below).

| | |
|---|---|
| | |
| Bayhydrol VP LS 2282 (aliphatic polyurethane dispersion), Bayer | 97.3 |
| Borchigel L 75 N (thickener), Borchers | 0.3 |
| Byk 347 (wetting agent), Byk Chemie | 0.4 |

To the prepared formulation the photoinitiator dispersions (1% active on total formulation) were added and stirred at low shear rate for 60 minutes at room temperature.

The coating was applied with a 100 µm slit coater to white chip boards, dried 10 minutes at 60°C and cured with two medium pressure mercury vapor lamps (2 x 80W/cm) at 5m/min for determining pendulum hardness and yellowing (measurement of L*a*b* according to DIN 6174).

| | Pendulum hardness (s) | b* |
|---|---|---|
| Without photoinitiator | 105 | 5.9 |
| 5% dispersion according to **Ex. 5** | 162 | 6.2 |
| 5% dispersion according to **Ex. 6** | 185 | 7.9 |

### Example A5:

The white pigmented UV curable water-borne coating of example A2 was used.

To the prepared formulation the photoinitiator dispersions (0.5% active on total formulation) and 1 % IRGACURE 500 (% active on formulation) were added and stirred at low shear rate for 30 minutes at room temperature.

The coating was applied with a 100 µm slit coater to white chip boards, dried 10 minutes at 60°C and cured with two medium pressure mercury vapor lamps (2 x 80W/cm) at 5m/min for determining pendulum hardness.

| | Pendulum hardness (s) |
|---|---|
| Without photoinitiator | 20 |
| 2.5% dispersion according to **Ex. 7** | 125 |
| 2.5% dispersion according to **Ex. 8** | 126 |
| 2.5% dispersion according to **Ex. 9** | 122 |

## Claims

1. A concentrated aqueous polymer dispersion with an average particle size of less than 1000 nm comprising
a) a polymer carrier prepared by heterophase radical polymerization of at least one ethylenically unsaturated monomer in the presence of
b) a photoinitiator and / or photolatent catalyst and
c) optionally a non-ionic, cationic or anionic surfactant,
wherein the weight ratio of the photoinitiator and / or photolatent catalyst to the polymer carrier is greater than 35 parts of photoinitiator and / or photolatent catalyst per 100 parts of polymer carrier, wherein the photoinitiator is selected from alpha-hydroxyketones, bisacylphosphine oxides or phenylglyoxylates.

2. A concentrated aqueous polymer dispersion according to claim 1 wherein the photoinitiator is a blend selected from alpha hydroxyketones with benzophenones, alpha hydroxyketones with bisacylphosphine oxides, alpha hydroxyketones with benzophenones and with bisacylphosphine oxides as well as blends of mono-and bisacylphosphine oxides.

3. A concentrated aqueous polymer dispersion according to claim 1, wherein the ethylenically unsaturated monomers are selected from the group consisting of C₁-C₁₈. acrylates, C₁-C₁₈methacrylates, acrylic acid, (meth)acrylic acid, styrene, vinyltoluene, hydroxy-functional acrylates or (meth)acrylates, acrylates or (meth)acrylates derived from alkoxylated alcohols and multifunctional acrylates or (meth)acrylates or mixtures thereof.

4. A concentrated aqueous polymer dispersion according to claim 1 comprising a mixture of at least two ethylenically unsaturated monomers and at least one crosslinking monomer which is bifunctional and which is selected from divinyl-benzene, ethylene glycol diacrylate, butylene glycol diacrylate or diethylene glycol diacrylate.

5. A process for the preparation of a concentrated aqueous polymer dispersion with an average particle size of less than 1000 nm comprising the step
polymerizing at least one ethylenically unsaturated monomer in the presence of a photoinitiator and/or a photolatent catalyst by heterophase radical polymerization; wherein the weight ratio of the photoinitiator and/or a photolatent catalyst to the polymer carrier formed from the ethylenically unsaturated monomer is greater than 35 parts of photoinitiator and/or a photolatent catalyst per 100 parts of polymer carrier, wherein the photoinitiator is selected from alpha-hydroxyketones, bisacylphosphine oxides or phenylglyoxylates.

6. A process according to claim 5 comprising the steps of
a) dissolving, emulsifying or dispersing a photoinitiator and/or photolatent catalyst in at least one ethylenically unsaturated monomer;
b) preparing a conventional oil in water emulsion of said photoinitiator and/or photolatent catalyst dissolved, emulsified or dispersed in at least one ethylenically unsaturated monomer;
c) homogenizing the conventional emulsion to a mini-emulsion wherein the droplets of the organic phase have an average diameter below 1000 nm;
a) polymerizing the mini-emulsion by adding a polymerization initiator;
wherein the weight ratio of the photoinitiator and/or a photolatent catalyst to the polymer carrier formed from the ethylenically unsaturated monomer is greater than 35 parts of photoinitiator and/or a photolatent catalyst per 100 parts of polymer carrier, wherein the photoinitiator is selected from alpha-hydroxyketones, bisacylphosphine oxides or phenyl-glyoxylates.

7. A process for preparing a polymer powder by preparing a concentrated aqueous polymer dispersion as described in claim 5 or 6 followed by vaporizing the volatile components of the concentrated aqueous polymer dispersion.

8. A polymer powder obtainable by a process according to claim 7.

9. Use of the aqueous polymer dispersion according to claim 1 or of the polymer powder according to claim 8 in aqueous or non-aqueous formulations, coatings, inks, adhesives or in formulations for electronic materials.

## Patentansprüche

1. Konzentrierte wässrige Polymerdispersion mit einer durchschnittlichen Partikelgröße von weniger als 1000 nm, umfassend:
a) einen Polymerträger, der hergestellt ist durch radikalische Heterophasenpolymerisation von mindestens einem ethylenisch ungesättigten Monomer in Gegenwart von
b) einem Photoinitiator und/oder photolatenten Katalysator und
c) gegebenenfalls einem nichtionischen, kationischen oder anionischen Tensid,
wobei das Gewichtsverhältnis von Photoinitiator und/oder photolatentem Katalysator zu dem Polymerträger größer als 35 Teile Photoinitiator und/oder photolatenter Katalysator auf 100 Teile Polymerträger ist, wobei der Photoinitiator ausgewählt ist aus α-Hydroxyketonen, Bisacylphosphinoxiden oder Phe-nylglyoxylaten.

2. Konzentrierte wässrige Polymerdispersion nach Anspruch 1, wobei der Photoinitiator ein Gemisch ausgewählt aus α-Hydroxyketonen mit Benzophenonen, α-Hydroxyketonen mit Bisacylphosphinoxiden, α-Hydroxyketonen mit Benzophenonen und mit Bisacylphosphinoxiden sowie Gemischen von Mono- und Bisacylphosphinoxiden ist.

3. Konzentrierte wässrige Polymerdispersion nach Anspruch 1, wobei die ethylenisch ungesättigten Monomere ausgewählt sind aus der Gruppe bestehend aus C₁-C₁₈-Acrylaten, C₁-C₁₈-Methacrylaten, Acrylsäure, Methacrylsäure, Styrol, Vinyltoluol, hydroxyfunktionalen Acrylaten oder Methacrylaten, Acrylaten oder Methacrylaten, die von alkoxylierten Alkoholen abgeleitet sind, und multifunktionalen Acrylaten oder Methacrylaten oder Mischungen davon.

4. Konzentrierte wässrige Polymerdispersion nach Anspruch 1, die eine Mischung von mindestens zwei ethylenisch ungesättigten Monomeren und mindestens einem Vernetzungsmonomer umfasst, welches bifunktional ist und ausgewählt ist aus Divinylbenzol, Ethylenglykoldiacrylat, Butylenglykoldiacrylat oder Diethylenglykoldiacrylat.

5. Verfahren zur Herstellung einer konzentrierten wässrigen Polymerdispersion mit einer durchschnittlichen Partikelgröße von weniger als 1000 nm, umfassend den Schritt des
Polymerisierens von mindestens einem ethylenisch ungesättigten Monomer in Gegenwart eines Photoinitiators und/oder photolatenten Katalysators durch radikalische Heterophasenpolymerisation, wobei das Gewichtsverhältnis von Photoinitiator und/oder einem photolatenten Katalysator zu dem Polymerträger, der aus dem ethylenisch ungesättigten Monomer gebildet ist, größer als 35 Teile Photoinitiator und/oder photolatenter Katalysator auf 100 Teile Polymerträger ist, wobei der Photoinitiator ausgewählt ist aus α-Hydroxyketonen, Bisacylphosphinoxiden oder Phenylgly-oxylaten.

6. Verfahren nach Anspruch 5, umfassend die Schritte:
a) Lösen, Emulgieren oder Dispergieren eines Photoinitiators und/oder photolatenten Katalysators in mindestens einem ethylenisch ungesättigten Monomer;
b) Herstellen einer konventionellen Öl-in-Wasser-Emulsion des Photoinitiators und/oder photolatenten Katalysators, gelöst, emulgiert oder dispergiert in mindestens einem ethylenisch ungesättigten Monomer;
c) Homogenisieren der konventionellen Emulsion zu einer Miniemulsion, wobei die Tröpfchen der organischen Phase einen mittleren Durchmesser unter 1000 nm aufweisen;
d) Polymerisieren der Miniemulsion durch Hinzufügen eines Polymerisationsinitiators;
wobei das Gewichtsverhältnis von Photoinitiator und/oder einem photolatenten Katalysator zu dem Polymerträger, der aus dem ethylenisch ungesättigten Monomer gebildet ist, größer als 35 Teile Photoinitiator und/oder photolatenter Katalysator auf 100 Teile Polymerträger ist, wobei der Photoinitiator ausgewählt ist aus α-Hydroxyketonen, Bisacylphosphinoxiden oder Phenylglyoxylaten.

7. Verfahren zum Herstellen eines Polymerpulvers durch Herstellen einer konzentrierten wässrigen Polymerdispersion wie in Anspruch 5 oder 6 beschrieben, wobei anschließend die flüchtigen Komponenten der konzentrierten wässrigen Polymerdispersion verdampft werden.

8. Polymerpulver, erhältlich mit einem Verfahren nach Anspruch 7.

9. Verwendung der wässrigen Polymerdispersion nach Anspruch 1 oder des Polymerpulvers nach Anspruch 8 in wässrigen oder nichtwässrigen Formulierungen, Beschichtungen, Tinten, Klebstoffen oder in Formulierungen für Elektronikmaterialien.

## Revendications

1. Dispersion aqueuse concentrée de polymère avec une taille moyenne de particules inférieure à 1000 nm comprenant
a) un support polymère préparé par polymérisation radicalaire hétérophasique d'au moins un monomère éthyléniquement insaturé en présence de
b) un photoinitiateur et/ou un catalyseur photolatent et
c) éventuellement un tensioactif non ionique, cationique ou anionique,
dans laquelle le rapport pondéral entre le photoinitiateur et/ou le catalyseur photolatent et le support polymère est supérieur à 35 parties de photoinitiateur et/ou de catalyseur photolatent pour 100 parties de support polymère, le photoinitiateur étant choisi parmi les alpha-hydroxycétones, les oxydes de bisacylphosphine ou les phénylglyoxylates.

2. Dispersion aqueuse concentrée de polymère selon la revendication 1 dans laquelle le photoinitiateur est un mélange choisi parmi les alpha-hydroxycétones avec les benzophénones, les alpha-hydroxycétones avec les oxydes de bisacylphosphine, les alpha-hydroxycétones avec les benzophénones et avec les oxydes de bisacylphosphine, ainsi que les mélanges d'oxydes de mono- et bisacylphosphine.

3. Dispersion aqueuse concentrée de polymère selon la revendication 1, dans laquelle les monomères éthyléniquement insaturés sont choisis dans le groupe constitué par les acrylates en C₁-C₁₈, les méthacrylates en C₁-C₁₈, l'acide acrylique, l'acide méthacrylique, le styrène, le vinyltoluène, les acrylates ou méthacrylates hydroxyfonctionnels, les acrylates ou méthacrylates dérivés d'alcools alcoxylés et les acrylates ou méthacrylates multifonctionnels ou les mélanges de ceux-ci.

4. Dispersion aqueuse concentrée de polymère selon la revendication 1 comprenant un mélange d'au moins deux monomères éthyléniquement insaturés et d'au moins un monomère réticulant qui est bifonctionnel et qui est choisi parmi le divinylbenzène, le diacrylate d'éthylène glycol, le diacrylate de butylène glycol et le diacrylate de diéthylène glycol.

5. Procédé de préparation d'une dispersion aqueuse concentrée de polymère avec une taille moyenne de particules inférieure à 1000 nm comprenant l'étape consistant à
polymériser au moins un monomère éthyléniquement insaturé en présence d'un photoinitiateur et/ou d'un catalyseur photolatent par polymérisation radicalaire hétérophasique ;
dans lequel le rapport pondéral entre le photoinitiateur et/ou le catalyseur photolatent et le support polymère formé à partir du monomère éthyléniquement insaturé est supérieur à 35 parties de photoinitiateur et/ou de catalyseur photolatent pour 100 parties de support polymère, le photoinitiateur étant choisi parmi les alpha-hydroxycétones, les oxydes de bisacylphosphine ou les phénylglyoxylates.

6. Procédé selon la revendication 5 comprenant les étapes consistant à
a) dissoudre, émulsionner ou disperser un photoinitiateur et/ou un catalyseur photolatent dans au moins un monomère éthyléniquement insaturé ;
b) préparer une émulsion huile dans eau conventionnelle desdits photoinitiateur et/ou catalyseur photolatent dissous, émulsionnés ou dispersés dans au moins un monomère éthyléniquement insaturé ;
c) homogénéiser l'émulsion conventionnelle en une mini-émulsion dans laquelle les gouttelettes de la phase organique ont un diamètre moyen inférieur à 1000 nm ;
d) polymériser la mini-émulsion en ajoutant un initiateur de polymérisation ;
dans lequel le rapport pondéral entre le photoinitiateur et/ou le catalyseur photolatent et le support polymère formé à partir du monomère éthyléniquement insaturé est supérieur à 35 parties de photoinitiateur et/ou de catalyseur photolatent pour 100 parties de support polymère, le photoinitiateur étant choisi parmi les alpha-hydroxycétones, les oxydes de bisacylphosphine ou les phénylglyoxylates.

7. Procédé de préparation d'une poudre de polymère par préparation d'une dispersion aqueuse concentrée de polymère telle que décrite dans la revendication 5 ou 6 suivie de la vaporisation des composants volatils de la dispersion aqueuse concentrée de polymère.

8. Poudre de polymère pouvant être obtenue par un procédé selon la revendication 7.

9. Utilisation de la dispersion aqueuse de polymère selon la revendication 1 ou de la poudre de polymère selon la revendication 8 dans des formulations aqueuses ou non aqueuses, des revêtements, des encres, des adhésifs ou dans des formulations pour matériaux électroniques.
